# EUROPÄISCHE PATENTSCHRIFT

(11) **EP 3 014 652 B1**
(45) Veröffentlichungstag und Bekanntmachung des Hinweises auf die Patenterteilung: **16.02.2022**
(21) Anmeldenummer: 14734459.2
(22) Anmeldetag: 27.06.2014
(51) Int. Cl.: H01L 21/36, H01L 21/02

(54) **SCHICHTSYSTEM FÜR DÜNNSCHICHTSOLARZELLEN MIT NATRIUMINDIUMSULFID-PUFFERSCHICHT**
COATING SYSTEM FOR THIN FILM SOLAR CELLS WITH SODIUM INDIUM SULPHIDE BUFFER COATING
SYSTÈME DE COUCHES POUR CELLULES SOLAIRES À COUCHES MINCES AVEC COUCHE-TAMPON EN SULFURE DE SODIUM

(30) Priorität: 27.06.2013 EP 13173956
(43) Veröffentlichungstag der Anmeldung: 04.05.2016
(73) Patentinhaber: (CNBM) Bengbu Design & Research Institute for Glass Industry Co., Ltd., Bengbu (CN)
(72) Erfinder: PALM, Jörg, 80797 München (DE); POHLNER, Stephan, 81541 München (DE); HAPP, Thomas, 81825 München (DE); DIETMÜLLER, Roland, 80636 München (DE); DALIBOR, Thomas, 82211 Herrsching am Ammersee (DE); JOST, Stefan, 81543 München (DE); VERMA, Rajneesh, 81243 München (DE)
(74) Vertreter: Ipey
(86) Internationale Anmeldenummer: PCT/EP2014/063747
(87) Internationale Veröffentlichungsnummer: WO 2014/207226

(56) Entgegenhaltungen:
- BARREAU N: "Indium sulfide and relatives in the world of photovoltaics", SOLAR ENERGY, PERGAMON PRESS. OXFORD, GB, Bd. 83, Nr. 3, 17. September 2008 (2008-09-17), Seiten 363-371, XP025937761, ISSN: 0038-092X, DOI: 10.1016/J.SOLENER.2008.08.008 [gefunden am 2008-09-17]
- BARREAU N ET AL: "New Cd-free buffer layer deposited by PVD: In2S3 containing Na compounds", THIN SOLID FILMS, ELSEVIER-SEQUOIA S.A. LAUSANNE, CH, Bd. 431-432, 1. Mai 2003 (2003-05-01), Seiten 326-329, XP004428660, ISSN: 0040-6090, DOI: 10.1016/S0040-6090(03)00216-5
- BARREAU N ET AL: "A study of bulk NaxCu1-xIn5S8 and its impact on the Cu(In,Ga)Se2/In2S3 interface of solar cells", SOLAR ENERGY MATERIALS AND SOLAR CELLS, ELSEVIER SCIENCE PUBLISHERS, AMSTERDAM, NL, Bd. 90, Nr. 12, 18. Januar 2006 (2006-01-18), Seiten 1840-1848, XP028002140, ISSN: 0927-0248, DOI: 10.1016/J.SOLMAT.2005.11.008 [gefunden am 2006-07-24]

## Beschreibung

Die vorliegende Erfindung liegt auf dem technischen Gebiet der Herstellung von Dünnschichtsolarzellen und betrifft ein Schichtsystem für Dünnschichtsolarzellen und ein Verfahren zur Herstellung eines solchen Schichtsystems.

Photovoltaische Schichtsysteme für Solarzellen zur direkten Umwandlung von Sonnenlicht in elektrische Energie sind hinlänglich bekannt. Der Begriff "Dünnschichtsolarzellen" bezieht sich auf Schichtsysteme mit Dicken von nur wenigen Mikrometern, die (Träger-)Substrate für eine ausreichende mechanische Festigkeit benötigen. Bekannte Substrate umfassen anorganisches Glas, Kunststoffe (Polymere) oder Metalle, insbesondere Metalllegierungen, und können in Abhängigkeit von der jeweiligen Schichtdicke und den spezifischen Materialeigenschaften als starre Platten oder biegsame Folien ausgestaltet sein.

Schichtsysteme für Dünnschichtsolarzellen sind in verschiedenen Ausführungen, je nach Substrat und aufgebrachten Materialien, auf dem Markt vorhanden. Die Materialien werden so gewählt, dass das einfallende Sonnenspektrum maximal ausgenutzt wird. Aufgrund der physikalischen Eigenschaften und der technologischen Handhabbarkeit sind Schichtsysteme mit amorphen, mikromorphen oder polykristallinen Silizium, Cadmium-Tellurid (CdTe), Gallium-Arsenid (GaAs), Kupfer-Indium- (Gallium)-Selenid-Sulfid (Cu(In,Ga) (S,Se)₂), Kupfer-Zink-Zinn-Sulfo-Selenid (CZTS aus der Gruppe der Kesterite) sowie organischen Halbleitern besonders für Dünnschichtsolarzellen geeignet. Der pentenäre Halbleiter Cu(In,Ga) (S,Se)₂ gehört zur Gruppe der Chalkopyrit-Halbleiter, die häufig als CIS (Kupferindiumdiselenid oder -sulfid) oder CIGS (Kupferindiumgalliumdiselenid, Kupferindiumgalliumdisulfid oder Kupferindiumgalliumdisulfoselenid) bezeichnet werden. S kann in der Abkürzung CIGS für Selen, Schwefel oder eine Mischung beider Chalkogene stehen.

Aktuelle Dünnschichtsolarzellen und Solarmodule auf Basis von Cu(In,Ga)(S,Se)₂ benötigen eine Pufferschicht zwischen einer p-leitenden Cu(In,Ga) (S,Se)₂-Absorberschicht und einer n-leitenden Frontelektrode. Die Frontelektrode enthält üblicherweise Zinkoxid (ZnO). Nach derzeitiger Erkenntnis ermöglicht diese Pufferschicht eine elektronische Anpassung zwischen Absorbermaterial und Frontelektrode. Sie bietet außerdem einen Schutz vor Sputterschäden im nachfolgenden Prozessschritt der Abscheidung der Frontelektrode durch DC-Magnetron-Sputtern. Zusätzlich verhindert sie den Stromabfluss von elektronisch gut-leitende in schlecht-leitende Bereiche durch den Aufbau einer hochohmigen Zwischenschicht zwischen p- und n-Halbleiter.

Bisher wurde am häufigsten Kadmiumsulfid (CdS) als Pufferschicht verwendet. Um gute Wirkungsgrade der Zelle erzeugen zu können, wurde Kadmiumsulfid bisher in einem chemischen Badprozess (CBD-Prozess) nasschemisch abgeschieden. Damit ist allerdings der Nachteil verbunden, dass der nasschemische Prozess nicht gut in den Prozessablauf der gegenwärtigen Produktion von Cu(In,Ga) (S,Se)₂-Dünnschichtsolarzellen passt.

Ein weiterer Nachteil der CdS-Pufferschicht besteht darin, dass sie das toxische Schwermetall Kadmium enthält. Dadurch entstehen höhere Produktionskosten, da erhöhte Sicherheitsvorkehrungen im Produktionsprozess getroffen werden müssen, beispielsweise bei der Entsorgung des Abwassers. Die Entsorgung des Produkts kann für den Kunden höhere Kosten verursachen, da der Hersteller je nach örtlicher Gesetzgebung zur Rücknahme, zur Entsorgung oder zum Recycling des Produkts gezwungen werden könnte.

Es wurden daher verschiedene Alternativen zum Puffer aus Kadmiumsulfid für unterschiedliche Absorber aus der Familie der Cu(In,Ga) (S,Se)₂-Halbleiter getestet, beispielsweise gesputtertes ZnMgO, durch CBD abgeschiedenes Zn(S,OH), durch CBD abgeschiedenes In(O,OH) und Indiumsulfid, abgeschieden durch Atomic Layer Deposition (ALD), Ion Layer Gas Deposition (ILGAR), Sprühpyrolyse oder Physical Vapor Deposition (PVD)-Verfahren, wie thermisches Verdampfen oder Sputtern.

Allerdings eignen sich diese Materialien noch nicht als Puffer für Solarzellen auf Basis von Cu(In,Ga)(S,Se)₂ für eine kommerzielle Nutzung, da sie nicht die gleichen Wirkungsgrade erreichen, wie solche mit einer CdS-Pufferschicht. Der Wirkungsgrad beschreibt das Verhältnis von eingestrahlter Leistung zur erzeugten elektrischen Leistung einer Solarzelle und beträgt für CdS-Pufferschichten für Laborzellen auf kleinen Flächen bis etwa 20 % sowie für großflächige Module zwischen 10% und 15%. Weiterhin zeigen alternative Pufferschichten zu große Instabilitäten, Hystereseeffekte oder Degradationen im Wirkungsgrad, wenn sie Licht, Wärme und/oder Feuchte ausgesetzt sind.

Ein weiterer Nachteil von CdS-Pufferschichten liegt darin begründet, dass Kadmiumsulfid ein direkter Halbleiter mit einer direkten elektronischen Bandlücke von etwa 2,4 eV ist. Daher wird in einer Cu(In,Ga) (S,Se)₂/CdS/ZnO-Solarzelle schon bei CdS-Schichtdicken von einigen 10 nm das einfallende Licht in erheblichem Umfang absorbiert. Das in der Pufferschicht absorbierte Licht geht für die elektrische Ausbeute verloren, da die erzeugten Ladungsträger in dieser Schicht gleich wieder rekombinieren und es in diesem Bereich des Heteroübergangs und im Puffermaterial viele als Rekombinationszentren wirkende Kristalldefekte gibt. Als Folge wird der Wirkungsgrad der Solarzelle kleiner, was für eine Dünnschichtsolarzelle nachteilig ist.

Ein Schichtsystem mit einer Pufferschicht auf Basis von Indiumsulfid ist beispielsweise aus WO 2009/141132 A2 bekannt. Das Schichtsystem besteht aus einem Chalcopyrit-Absorber der CIGS-Familie und insbesondere aus Cu(In,Ga)(S,Se)₂ in Verbindung mit einer Pufferschicht aus Indiumsulfid. Die Indiumsulfid(InᵥS_{w})-Pufferschicht hat beispielsweise eine leicht indiumreiche Zusammensetzung mit v/(v+w)=41% bis 43%. Die Indiumsulfid-Pufferschicht kann mit verschiedenen nicht-nasschemischen Verfahren abgeschieden werden, beispielsweise durch thermisches Verdampfen, Elektronenstrahl-Verdampfen, Ion Layer Gas Reaction (ILGAR), Kathodenzerstäubung (Sputtern), Atomic Layer Deposition (ALD) oder Sprühpyrolyse.

In der bisherigen Entwicklung dieser Schichtsysteme und der Herstellungsverfahren hat sich jedoch gezeigt, dass der Wirkungsgrad von Solarzellen mit Indiumsulfid-Pufferschicht kleiner ist als der mit CdS-Pufferschichten.

Eine Pufferschicht auf Basis von natriumlegiertem Indiumsulfid ist aus Barreau et al.: "Study of the new β-In2S3 containing Na thin films. Part II: Optical and electrical characterization of thin films", Journal of Crystal Growth, 241 (2002), Seiten 51-56, bekannt.

Wie sich aus Fig. 5 dieser Veröffentlichung ergibt, wird durch eine Vergrößerung des Natriumanteils von 0 Atom-% auf 6 Atom-% in der Pufferschicht die Bandlücke auf Werte bis 2,95 eV erhöht. Da die Pufferschicht jedoch unter anderem die Aufgabe der Bandanpassung von der Absorberschicht an die Frontelektrode hat, führt eine derart hohe Bandlücke im Zusammenspiel mit typischen Absorbermaterialien zu einer Verschlechterung der elektrischen Eigenschaften der Solarzellen.

Demgegenüber besteht die Aufgabe der vorliegenden Erfindung darin, ein Schichtsystem auf Basis eines Chalkopyritverbindungshalbleiters mit einer Pufferschicht bereitzustellen, das einen hohen Wirkungsgrad und hohe Stabilität aufweist, wobei die Herstellung kostengünstig und umweltverträglich sein soll. Diese und weitere Aufgaben werden nach dem Vorschlag der Erfindung durch ein Schichtsystem sowie ein Verfahren zur Herstellung eines Schichtsystems mit den Merkmalen der nebengeordneten Patentansprüche gelöst. Vorteilhafte Ausgestaltungen der Erfindung sind durch die Merkmale der Unteransprüche angegeben.

Das erfindungsgemäße Schichtsystem für Dünnschichtsolarzellen umfasst eine Absorberschicht zur Absorption von Licht. Vorzugsweise, jedoch nicht zwingend, enthält die Absorberschicht einen Chalkopyritverbindungshalbleiter, insbesondere Cu₂ZnSn(S,Se)₄, Cu(In,Ga,Al)(S,Se)₂, CuInSe₂, CuInS₂, Cu(In,Ga)Se₂ oder Cu(In,Ga)(S,Se)₂. Bei einer vorteilhaften Ausgestaltung der Absorberschicht besteht diese aus einem solchen Chalkopyritverbindungshalbleiter.

Des Weiteren umfasst das erfindungsgemäße Schichtsystem eine auf der Absorberschicht angeordnete Pufferschicht, welche Natriumindiumsulfid gemäß der Summenformel NaₓIn_{y-x/3}S mit 0,063 ≤ x ≤ 0,625 und 0,681 ≤ y ≤ 1,50 enthält.

Die Summenformel NaₓIn_{y-x/3}S beschreibt die Stoffmengenanteile von Natrium, Indium und Schwefel in der Pufferschicht, bezogen auf Natriumindiumsulfid, wobei der Index x die Stoffmenge an Natrium wiedergibt und für die Stoffmenge von Indium der Index x und ein weiterer Index y maßgebend ist, wobei sich die Stoffmenge von Indium aus dem Wert von y-x/3 ergibt. Für die Stoffmenge von Schwefel beträgt der Index stets 1. Um den Stoffmengenanteil eines Stoffs in Atom-% zu erhalten, wird der Index des Stoffs durch die Summe aller Indizes der Summenformel geteilt. Beträgt beispielsweise x = 1 und y = 1,33, so ergibt sich die Summenformel NaInS, wobei Natrium, Indium und Schwefel, bezogen auf Natriumindiumsulfid, jeweils einen Stoffmengenanteil von ca. 33 Atom-% haben.

Wie hier und im Weiteren verwendet, beschreibt der Stoffmengenanteil eines Stoffs (Element) von Natriumindiumsulfid in Atom-% den Anteil der Stoffmenge dieses Stoffs (Elements) in Natriumindiumsulfid bezogen auf die Summe der Stoffmengen aller Stoffe (Elemente) der Summenformel. Der auf Natriumindiumsulfid bezogene Stoffmengenanteil eines Stoffs entspricht dem Stoffmengenanteil des Stoffs in der Pufferschicht, falls in der Pufferschicht keine weiteren Elemente als Natrium, Indium und Schwefel sind bzw. diese Elemente einen vernachlässigbaren Anteil haben.

Generell ist die Pufferschicht zusammengesetzt (bzw. besteht) aus Natriumindiumsulfid gemäß der Summenformel NaₓIn_{y-x/3}S mit 0,063 ≤ x ≤ 0,625 und 0,681 ≤ y ≤ 1,50 und einem oder mehreren weiteren hiervon verschiedenen Bestandteilen (Verunreinigungen). Bei einer vorteilhaften Ausgestaltung der Erfindung besteht die Pufferschicht im Wesentlichen aus Natriumindiumsulfid gemäß der Summenformel NaₓIn_{y-x/3}S mit 0,063 ≤ x ≤ 0,625 und 0,681 ≤ y ≤ 1,50. Dies bedeutet, dass die weiteren Bestandteile (Verunreinigungen) einen vernachlässigbaren Anteil haben.

Falls nicht auf die Elemente der Summenformel von Natriumindiumsulfid bezogen, beschreibt der Stoffmengenanteil eines Stoffs (Verunreinigung) in Atom-% den Anteil der Stoffmenge dieses Stoffs bezogen auf die Summe der Stoffmengen aller Stoffe in der Pufferschicht (d.h. bezogen auf Natriumindiumsulfid und Verunreinigungen).

Erfindungsgemäß beträgt der prozentuale Anteil (Atom-%) aller Elemente von Natriumindiumsulfid gemäß der Summenformel NaₓIn_{y-x/3}S mit 0,063 ≤ x ≤ 0,625 und 0,681 ≤ y ≤ 1,50 in der Pufferschicht mindestens 75%, vorzugsweise mindestens 80%, stärker bevorzugt mindestens 85%, noch stärker bevorzugt mindestens 90%, noch stärker bevorzugt mindestens 95% und am stärksten bevorzugt mindestens 99%.

Da die Elemente der Pufferschicht jeweils in verschiedenen Oxidationsstufen vorliegen können, werden im Folgenden alle Oxidationsstufen einheitlich mit dem Namen des Elements bezeichnet, sofern dies nicht explizit anders gekennzeichnet wird. Beispielsweise ist unter Natrium deshalb elementares Natrium, Natriumionen sowie Natrium in Verbindungen zu verstehen.

Durch die Legierung mit Natrium weist die Natriumindiumsulfid-Pufferschicht des erfindungsgemäßen Schichtsystems vorteilhaft eine amorphe oder feinkristalline Struktur auf. Hierbei ist die mittlere Korngröße durch die Dicke der Pufferschicht begrenzt und liegt vorteilhaft im Bereich von 8 nm bis 100 nm und stärker bevorzugt im Bereich von 20 nm bis 60 nm, beispielsweise 30 nm.

Wie Untersuchungen ergeben haben, kann durch die amorphe oder feinkristalline Struktur das Eindiffundieren von Kupfer (Cu) aus der Absorberschicht in die Pufferschicht gehemmt werden. Dies lässt sich dadurch erklären, dass Natrium und Kupfer im Indiumsulfid-Gitter die gleichen Plätze einnehmen und diese Plätze durch Natrium belegt sind. Die Eindiffusion von größeren Mengen an Kupfer ist jedoch unvorteilhaft, da die Bandlücke der Pufferschicht durch Kupfer reduziert wird. Dies führt zu einer erhöhten Absorption des Lichtes in der Pufferschicht und damit zu einer Reduzierung des Wirkungsgrades. Durch einen Stoffmengenanteil von Kupfer in der Pufferschicht von weniger als 7 Atom-%, insbesondere weniger als 5 Atom-%, kann ein besonders hoher Wirkungsgrad der Solarzelle sichergestellt werden.

In einer vorteilhaften Ausgestaltung des erfindungsgemäßen Schichtsystems ist in der Pufferschicht Natriumindiumsulfid gemäß der Summenformel NaₓIn_{y-x/3}S mit 0,063 ≤ x ≤ 0,469 und 0,681 ≤ y ≤ 1,01 enthalten. Für diese Werte konnten besonders hohe Wirkungsgrade gemessen werden. Bislang beste Wirkungsgrade konnten für eine Pufferschicht gemessen werden, in der Natriumindiumsulfid gemäß der Summenformel NaₓIn_{y-x/3}S mit 0,13 ≤ x ≤ 0,32, und 0,681 ≤ y ≤ 0,78 enthalten ist.

In einer weiteren vorteilhaften Ausgestaltung des erfindungsgemäßen Schichtsystems weist die Pufferschicht einen Stoffmengenanteil an Natrium von mehr als 5 Atom-%, insbesondere mehr als 7 Atom-%, insbesondere mehr als 7,2 Atom-%, auf. Für einen solchen hohen Natriumanteil konnten besonders hohe Wirkungsgrade gemessen werden. Des weiteren gilt für eine erfindungsgemäße Pufferschicht, dass das Verhältnis der Stoffmengenanteile von Natrium und Indium größer als 0,2 ist.

Bei einer vorteilhaften Ausgestaltung enthält die Pufferschicht einen Stoffmengenanteil an einem Halogen, insbesondere Chlor von weniger als 7 Atom-%, insbesondere weniger als 5 Atom-%, wobei es bevorzugt ist, wenn die Pufferschicht vollständig halogenfrei ist. Hierdurch kann ein besonders hoher Wirkungsgrad der Solarzelle erreicht werden. Wie bereits erwähnt, ist es vorteilhaft, wenn die Pufferschicht einen Stoffmengenanteil von Kupfer von weniger als 7 Atom-%, insbesondere weniger als 5 Atom-%, aufweist, wobei es bevorzugt ist, wenn die Pufferschicht vollständig kupferfrei ist.

In einer weiteren vorteilhaften Ausgestaltung enthält die erfindungsgemäße Pufferschicht einen Stoffmengenanteil an Sauerstoff von maximal 10 Atom-%. Sauerstoff kann als Verunreinigung auftreten, da beispielsweise Indiumsulfid hygroskopisch ist. Sauerstoff kann auch über Restwasserdampf aus den Beschichtungsanlagen eingeschleppt werden. Durch einen Stoffmengenanteil ≤ 10 Atom-% von Sauerstoff in der Pufferschicht kann ein besonders hoher Wirkungsgrad der Solarzelle sichergestellt werden.

In einer weiteren vorteilhaften Ausgestaltung des erfindungsgemäßen Schichtsystems weist die Pufferschicht keinen wesentlichen Anteil an weiteren Elementen außer Natrium, Indium und Schwefel, Cl und O auf. Das bedeutet, dass die Pufferschicht nicht mit weiteren Elementen wie beispielsweise Kohlenstoff versehen ist und höchstens fertigungstechnisch nicht vermeidbare Stoffmengenanteile an weiteren Elementen von < 1 Atom-% enthält. Dadurch lässt sich ein hoher Wirkungsgrad der Solarzelle sicherstellen.

Bei einer besonders vorteilhaften Ausgestaltung der Erfindung beträgt die Summe der Stoffmengenanteile aller Verunreinigungen (d.h. alle Stoffe, die verschieden sind von Natriumindiumsulfid gemäß der Summenformel NaₓIn_{y-x/3}S mit 0,063 ≤ x ≤ 0,625 und 0,681 ≤ y ≤ 1,50) in der Pufferschicht maximal 25%, vorzugsweise maximal 20%, stärker bevorzugt maximal 15%, noch stärker bevorzugt maximal 10%, noch stärker bevorzugt maximal 5% und am stärksten bevorzugt maximal 1%.

In einer typischen Ausgestaltung besteht die Pufferschicht aus einem an die Absorberschicht angrenzenden ersten Schichtbereich und einem an den ersten Schichtbereich angrenzenden zweiten Schichtbereich, wobei die Schichtdicke des ersten Schichtbereichs kleiner ist als die Schichtdicke des zweiten Schichtbereichs oder gleich der Schichtdicke des zweiten Schichtbereichs ist, und wobei der Stoffmengenanteil von Natrium im ersten Schichtbereich ein Maximum aufweist und sowohl zur Absorberschicht als auch zum zweiten Schichtbereich hin abnimmt.

Eine vorteilhafte Ausgestaltung der erfindungsgemäßen Pufferschicht weist eine Schichtdicke von 10 nm bis 100 nm und bevorzugt von 20 nm bis 60 nm auf.

Die Erfindung erstreckt sich weiterhin auf Dünnschichtsolarzellen mit dem erfindungsgemäßen Schichtsystem sowie Solarzellenmodule, die diese Solarzellen beinhalten.

Eine erfindungsgemäße Dünnschichtsolarzelle umfasst ein Substrat, eine Rückelektrode, die auf dem Substrat angeordnet ist, ein erfindungsgemäßes Schichtsystem, das auf der Rückelektrode angeordnet ist, und eine Frontelektrode, die auf der zweiten Pufferschicht angeordnet ist.

Das Substrat ist vorzugsweise ein Metall-, Glas-, Kunststoff- oder Keramiksubstrat, wobei Glas bevorzugt wird. Es können aber auch andere transparente Trägermaterialien, insbesondere Kunststoffe verwendet werden. Die Rückelektrode umfasst vorteilhafterweise Molybdän (Mo) oder andere Metalle. In einer vorteilhaften Ausgestaltung der Rückelektrode weist diese eine Molybdänteilschicht auf, die an die Absorberschicht angrenzt, und eine Siliziumnitridteilschicht (SiN), die an die Molybdän-Teilschicht angrenzt. Derartige Rückelektrodensysteme sind beispielsweise aus EP 1356528 A1 bekannt. Die Frontelektrode enthält bevorzugt ein transparentes leitendes Oxid (TCO), besonders bevorzugt Aluminium-, Gallium- oder Bor-dotiertes Zinkoxid und/oder Indium-Zinnoxid (ITO).

Ferner umfasst die Erfindung ein Verfahren zur Herstellung eines erfindungsgemäßen Schichtsystems, wobei
a) eine Absorberschicht, welche insbesondere einen Chalcopyrithalbleiter enthält, hergestellt wird und
b) eine Pufferschicht auf der Absorberschicht angeordnet wird, wobei die Pufferschicht NaₓIn_{y-x/3}S mit 0,063 ≤ x ≤ 0,625 und 0,681 ≤ y ≤ 1,50 enthält. Der prozentuale Anteil aller Elemente von NaₓIn_{y-x/3}S in der Pufferschicht beträgt mindestens 75 Atom-% und das Verhältnis der Stoffmengenanteile von Natrium und Indium grösser als 0,2 ist.

Das in dem erfindungsgemäßen Verfahren hergestellte erfindungsgemäße Schichtsystem ist wie im Zusammenhang mit dem erfindungsgemäßen Schichtsystem beschrieben ausgebildet.

Zweckmäßig wird die Absorberschicht in einem RTP-("rapid thermal processing") Prozess auf die Rückelektrode auf einem Substrat aufgebracht.

Für Cu(In,Ga)(S, Se)₂-Absorberschichten wird dabei zunächst eine Vorläuferschicht auf das Substrat mit Rückelektrode abgeschieden. Die Vorläuferschicht enthält die Elemente Kupfer, Indium und Gallium, die durch Sputtern aufgebracht werden. Bei der Beschichtung durch die Vorläuferschicht wird eine gezielte Natriumdosis in die Vorläuferschicht eingebracht, wie beispielsweise aus EP 715 358 B1 bekannt ist. Des Weiteren enthält die Vorläuferschicht elementares Selen, das durch thermisches Verdampfen aufgebracht wird. Bei diesen Prozessen liegt die Substrattemperatur unter 100°C, so dass die Elemente im Wesentlichen als Metalllegierung und elementares Selen unreagiert erhalten blieben. Anschließend wird diese Vorläuferschicht in einem schnellen Temperverfahren (rapid thermal processing, RTP) in schwefelhaltiger Atmosphäre zu einem Cu(In,Ga)(S,Se)₂-Chalco-genidhalbleiter reagiert.

Bei einer vorteilhaften Ausgestaltung wird zur Herstellung der Pufferschicht in Schritt b) Indiumsulfid, bevorzugt In₂S₃, auf die Absorberschicht abgeschieden und vor und/oder während und/oder nach der Abscheidung von Indiumsulfid ein Natriumsulfid, bevorzugt Na₂S, insbesondere ein Natriumpolysulfid, bevorzugt Na₂S₃ oder Na₂S₄, oder ein Natriumindat, bevorzugt NaInS₂ oder NaIn₅S₈, auf die Absorberschicht abgeschieden.

Beispielsweise wird Natriumsulfid oder Natriumindat alternierend mit Indiumsulfid abgeschieden, beispielsweise beginnend mit Natriumsulfid oder Natriumindat.

Zur Herstellung der Pufferschicht sind prinzipiell alle chemisch-physikalischen Abscheideverfahren geeignet, bei denen das Verhältnis von Indium zu Schwefel sowie der Natriumanteil zum Indiumsulfidanteil gesteuert werden kann. Vorteilhafterweise wird die erfindungsgemäße Pufferschicht durch nasschemische Badabscheidung, Atomic Layer Deposition (ALD), Ion Layer Gas Deposition (ILGAR), Sprühpyrolyse, Chemical Vapour Deposition (CVD) oder Physical Vapor Deposition (PVD) auf die Absorberschicht aufgebracht. Die erfindungsgemäße Pufferschicht wird bevorzugt durch Sputtern (Kathodenzerstäubung), thermisches Verdampfen oder Elektronenstrahlverdampfen abgeschieden, besonders bevorzugt aus separaten Quellen für Indiumsulfid und Natriumsulfid oder Natriumindat. Indiumsulfid kann entweder aus getrennten Quellen für Indium und Schwefel verdampft werden oder aus einer Quelle mit einem In₂S₃-Verbindungshalblei-termaterial. Auch andere Indiumsulfide (In₆S₇ oder InS) sind in Kombination mit einer Schwefelquelle möglich.

Die erfindungsgemäße Pufferschicht wird vorteilhafterweise mit einem Vakuumverfahren abgeschieden. Das Vakuumverfahren hat den besonderen Vorteil, dass im Vakuum der Einbau von Sauerstoff oder Hydroxid verhindert wird. Hydroxid-Komponenten in der Pufferschicht sind vermutlich verantwortlich für Transienten des Wirkungsgrades bei Einwirkung von Wärme und Licht. Des Weiteren haben Vakuumverfahren den Vorteil, dass das Verfahren ohne Nasschemie auskommt und Standard-Vakuumbeschichtungsanlagen verwendet werden können.

In einer vorteilhaften Ausführungsform des erfindungsgemäßen Verfahrens wird Natriumsulfid (vorzugsweise Na₂S) oder Natriumindat aus mindestens einer separaten, zweiten Quelle verdampft. Die Anordnung der Abscheidungsquellen kann derart gestaltet sein, dass sich die Dampfkeulen der Quellen nicht überlappen. Alternativ kann die Anordnung der Abscheidungsquellen derart gestaltet sein, dass sich die Dampfkeulen der Quellen vollständig oder teilweise überlappen. Dampfkeule im Sinne der vorliegenden Erfindung bedeutet der Bereich vor dem Auslass der Quelle, welcher für die Abscheidung des verdampften Materials auf einem Substrat hinsichtlich Aufdampfrate und Homogenität technisch geeignet ist. Die Quelle ist beispielsweise eine Effusionszelle, ein Schiffchen oder Tiegel eines thermischen Verdampfers, einer Widerstandsheizung, eines Elektronenstrahlverdampfer oder eines Linearverdampfers.

In einer vorteilhaften Ausgestaltung des erfindungsgemäßen Verfahrens wird die Absorberschicht in einem In-Line-Verfahren oder in einem Rotations-Verfahren an mindestens einer Dampfkeule eines Natriumsulfids oder Natriumindats und mindestens einer Dampfkeule von Indiumsulfid oder Indium und Schwefel vorbeigeführt. Beispielsweise kann die Absorberschicht an einer Dampfkeule eines Natriumsulfids oder Natriumindats und anschließend an einer Dampfkeule von Indiumsulfid vorbeigeführt werden. Ebenso ist es beispielsweise möglich, dass die Absorberschicht an einer Dampfkeule eines Natriumsulfids oder Natriumindats, welche sich zwischen zwei Dampfkeulen von Indiumsulfid befindet, vorbeigeführt wird.

Ein weiterer Aspekt der Erfindung umfasst die Verwendung eines erfindungsgemäßen Schichtsystems in einer Dünnschichtsolarzelle oder einem Solarzellenmodul.

### Kurze Beschreibung der Zeichnungen

Die Erfindung wird nun anhand eines Ausführungsbeispiels näher erläutert, wobei Bezug auf die beigefügten Figuren genommen wird. Es zeigen:
- Fig. 1: eine schematische Querschnittsansicht einer erfindungsgemäßen Dünnschichtsolarzelle mit erfindungsgemäßen Schichtsystem;
- Fig. 2A: ein ternäres Diagramm zur Darstellung der Zusammensetzung der Natriumindiumsulfid-Pufferschicht der Dünnschichtsolarzelle von Fig. 1;
- Fig. 2B: einen vergrößerten Ausschnitt des ternären Diagramms von Fig. 2A mit dem erfindungsgemäß beanspruchten Bereich;
- Fig. 3A: eine Messung des Wirkungsgrads der Dünnschichtsolarzelle von Fig. 1 in Abhängigkeit des Natrium-Indium-Verhältnis der Pufferschicht;
- Fig. 3B: eine Messung des Wirkungsgrads der Dünnschichtsolarzelle von Fig. 1 in Abhängigkeit des absoluten Natriumgehalts der Pufferschicht;
- Fig. 4: eine Messung der Bandlücke der Pufferschicht des Schichtsystems von Fig. 1 in Abhängigkeit des absoluten Natriumgehalts der Pufferschicht;
- Fig. 5: eine Messung des Tiefenprofils der Natriumverteilung in der Pufferschicht des Schichtsystems von Fig. 1 mit unterschiedlich hohen Natriumanteilen;
- Fig. 6: ein Ausführungsbeispiel der erfindungsgemäßen Verfahrensschritte anhand eines Flussdiagramms;
- Fig. 7: eine schematische Darstellung eines In-Line-Verfahrens zur Herstellung einer erfindungsgemäßen Pufferschicht;
- Fig. 8: eine schematische Darstellung eines alternativen In-Line-Verfahrens zur Herstellung einer erfindungsgemäßen Pufferschicht;
- Fig. 9: eine schematische Darstellung eines Rotations-Verfahrens zur Herstellung einer erfindungsgemäßen Pufferschicht.

### Ausführliche Beschreibung der Zeichnungen

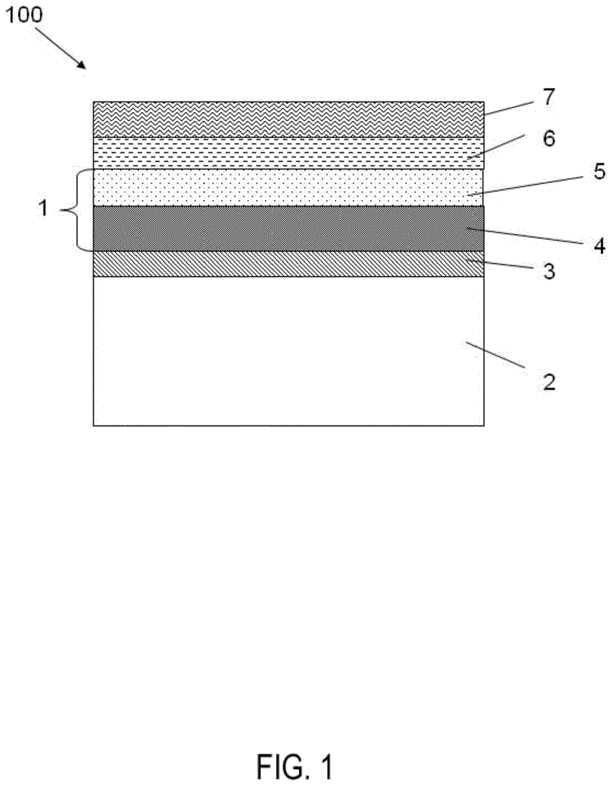

Figur 1 zeigt rein schematisch ein bevorzugtes Ausführungsbeispiel einer erfindungsgemäßen Dünnschichtsolarzelle 100 mit einem erfindungsgemäßen Schichtsystem 1 in einer Querschnittsansicht. Die Dünnschichtsolarzelle 100 enthält ein Substrat 2 und eine Rückelektrode 3. Auf der Rückelektrode 3 ist ein erfindungsgemäßes Schichtsystem 1 angeordnet. Das erfindungsgemäße Schichtsystem 1 umfasst eine Absorberschicht 4 und eine Pufferschicht 5. Auf dem Schichtsystem 1 ist eine zweite Pufferschicht 6 und eine Frontelektrode 7 angeordnet.

Das Substrat 2 besteht hier beispielsweise aus anorganischem Glas, wobei gleichermaßen andere isolierende Materialien mit genügender Festigkeit, sowie inertem Verhalten gegenüber den bei der Herstellung der Dünnschichtsolarzelle 100 durchgeführten Prozessschritten eingesetzt werden können, beispielsweise Kunststoffe, insbesondere Polymere oder Metalle, insbesondere Metall-Legierungen. In Abhängigkeit der Schichtdicke und den spezifischen Materialeigenschaften kann das Substrat 2 als starre Platte oder biegsame Folie ausgestaltet sein. Im vorliegenden Ausführungsbeispiel beträgt die Schichtdicke des Substrats 2 beispielsweise von 1 mm bis 5 mm.

Auf der lichteintrittsseitigen Oberfläche des Substrats 2 ist eine Rückelektrode 3 angeordnet. Die Rückelektrode 3 besteht beispielsweise aus einem lichtundurchlässigen Metall. Sie kann beispielsweise durch Aufdampfen oder magnetfeldunterstützte Kathodenzerstäubung auf dem Substrat 2 abgeschieden werden. Die Rückelektrode 3 besteht beispielsweise aus Molybdän (Mo), Aluminium (Al), Kupfer (Cu), Titan (Ti), Zink (Zn) oder aus einem Mehrschichtsystem mit einem solchen Metall, beispielsweise Molybdän (Mo). Die Schichtdicke der Rückelektrode 3 ist hier geringer als 1 µm, liegt vorzugsweise im Bereich von 300 nm bis 600 nm und beträgt beispielsweise 500 nm. Die Rückelektrode 3 dient als Rückseitenkontakt der Dünnschichtsolarzelle 100. Zwischen dem Substrat 2 und der Rückelektrode 3 kann eine Alkali-Barriere angeordnet sein, welche beispielsweise aus Si₃N₄, SiON oder SiCN besteht. Dies ist in Figur 1 nicht näher dargestellt.

Auf der Rückelektrode 3 ist ein erfindungsgemäßes Schichtsystem 1 angeordnet. Das Schichtsystem 1 enthält eine Absorberschicht 4, beispielsweise aus Cu(In,Ga)(S,Se)₂, die unmittelbar auf der Rückelektrode 3 aufgebracht ist. Die Absorberschicht 4 aus Cu(InGa)(S,Se)₂ wurde beispielsweise in dem eingangs beschriebenen RTP-Prozess abgeschieden. Die Absorberschicht 4 hat beispielsweise eine Dicke von 1,5 µm.

Auf der Absorberschicht 4 ist eine Pufferschicht 5 angeordnet. Die Pufferschicht 5 enthält NaₓIn_{y-x/3}S mit 0,063 ≤ x ≤ 0,625, 0,681 ≤ y ≤ 1,50, bevorzugt 0,063 ≤ x ≤ 0,469, 0,681 ≤ y ≤ 1,01 und noch stärker bevorzugt 0,13 ≤ x ≤ 0,32, 0,681 ≤ y ≤ 0,78. Die Schichtdicke der Pufferschicht 5 liegt im Bereich von 20 nm bis 60 nm und beträgt beispielsweise 30 nm.

Oberhalb der Pufferschicht 5 kann optional eine zweite Pufferschicht 6 angeordnet sein. Die Pufferschicht 6 enthält beispielsweise undotiertes Zinkoxid (i-ZnO). Oberhalb der zweiten Pufferschicht 6 ist eine Frontelektrode 7 angeordnet, die als Vorderseitenkontakt dient und für Strahlung im sichtbaren Spektralbereich transparent ist ("Fensterschicht"). In der Regel wird für die Frontelektrode 7 ein dotiertes Metalloxid (TCO = Transparent Conductive Oxide) eingesetzt, beispielsweise n-leitendes, Aluminium (Al)-dotiertes Zinkoxid (ZnO), Bor (B)-dotiertes Zinkoxid (ZnO), oder Gallium (Ga)-dotiertes Zinkoxid (ZnO). Die Schichtdicke der Frontelektrode 7 beträgt beispielsweise etwa 300 bis 1500 nm. Zum Schutz vor Umwelteinflüssen kann auf der Frontelektrode 7 eine beispielsweise aus Polyvinylbutyral (PVB), Ethylenvinylacetat (EVA) oder Silikonen bestehende Kunststoffschicht (Verkapselungsfolie) aufgebracht sein. Zudem kann eine für Sonnenlicht transparente Deckplatte vorgesehen sein, die beispielsweise aus extraweißem Glas (Frontglas) mit geringem Eisengehalt besteht und eine Dicke von beispielsweise 1 bis 4 mm aufweist.

Der beschriebene Aufbau einer Dünnschichtsolarzelle oder eines Dünnschichtsolarmoduls ist dem Fachmann beispielsweise aus im Handel verfügbaren Dünnschichtsolarzellen oder Dünnschichtsolarmodulen wohlbekannt und wurde zudem bereits in zahlreichen Druckschriften der Patentliteratur eingehend beschrieben, beispielsweise in DE 19956735 B4.

In der in Figur 1 gezeigten Substratkonfiguration grenzt die Rückelektrode 3 an das Substrat 2 an. Es versteht sich, dass das Schichtsystem 1 gleichermaßen über eine Superstratkonfiguration verfügen kann, bei welcher das Substrat 2 transparent und die Frontelektrode 7 auf einer der Lichteintrittsseite abgewandten Oberfläche des Substrats 2 angeordnet ist.

Das Schichtsystem 1 kann zur Herstellung von integriert serienverschalteter Dünnschichtsolarzellen 100 dienen, wobei das Schichtsystem 1, die Rückelektrode 3 und die Frontelektrode 7 in an sich bekannter Weise durch verschiedene Strukturierungslinien ("P1" für Rückelektrode, "P2" für Kontakt Frontelektrode/Rückelektrode und "P3" für Trennung der Frontelektrode) strukturiert wird.

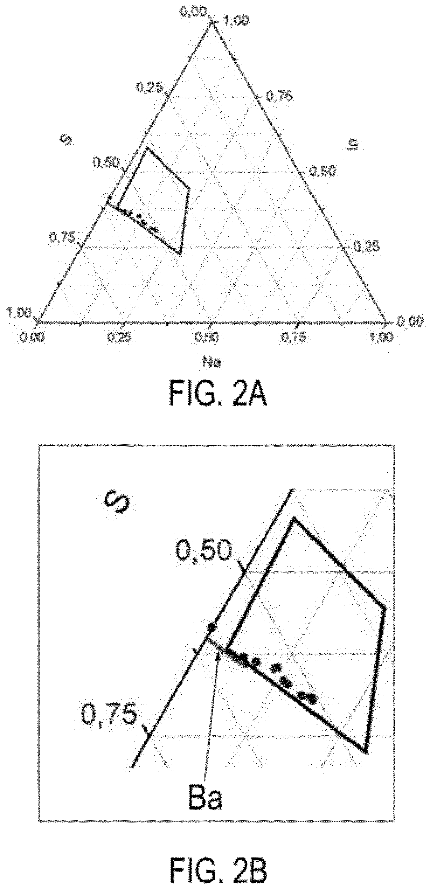

In Fig. 2A ist ein ternäres Diagramm zur Darstellung der Zusammensetzung NaₓIn_{y-x/3}S der Pufferschicht 5 der Dünnschichtsolarzelle 100 von Fig. 1 gezeigt. Im ternären Diagramm sind für die Bestandteile Schwefel (S), Indium (In) und Natrium (Na) der Pufferschicht 5 die relativen Anteile angegeben. Der erfindungsgemäß beanspruchte Zusammensetzungsbereich, gegeben durch 0,063 ≤ x ≤ 0,625 und 0,681 ≤ y ≤ 1,50, ist durch den mit durchgezogener Linie umrandeten Bereich gegeben. Datenpunkte innerhalb des umrandeten Zusammensetzungsbereichs geben beispielhafte Zusammensetzungen der Pufferschicht 5 an. Figur 2B zeigt einen vergrößerten Ausschnitt des ternären Diagramms mit dem erfindungsgemäß beanspruchten Zusammensetzungsbereich.

Die mit "Ba" gekennzeichnete Gerade, welche nicht zum erfindungsgemäß beanspruchten Zusammensetzungsbereich gehört, gibt eine in der eingangs zitierten Druckschrift von Barreau et al. gezeigte Zusammensetzung für eine Natriumindiumsulfid-Pufferschicht an. Diese kann über die Summenformel NaₓIn_{21.33-x}/S₃₂ mit 1 ≤ x ≤ 4 beschrieben werden. Demnach ist die Gerade durch den Startpunkt In₂S₃ und den Endpunkt NaIn₅S₈ markiert. Charakteristisch hierbei ist, dass dünne Schichten einen maximalen Natriumanteil von 5 Atom-% aufweisen (Na/In = 0,12) und dass ein Einkristall einen Natriumanteil von 7 Atom-% (Na/In = 0,2) aufweist. Für diese Schichten wurde eine hohe Kristallinität berichtet.

Wie eingangs bereits dargestellt, weisen diese Pufferschichten bei einem Natriumgehalt von mehr als 6 Atom-% eine Bandlücke von 2,95 eV auf, was eine ungünstige Bandanpassung zum Absorber bzw. zur Frontelektrode zur Folge hat und somit zu einer Verschlechterung der elektrischen Eigenschaften führt, so dass diese Pufferschichten zur Verwendung in Dünnschichtsolarzellen ungeeignet sind. Der erfindungsgemäß beanspruchte Zusammensetzungsbereich ist laut Barreau et al. nicht zugänglich.

Erfindungsgemäß wird dieser Nachteil dadurch vermieden, dass der Natriumanteil deutlich höhere Werte als Na/In = 0,12 bzw. 0,2 erreicht. Wie die Erfinder überraschender Weise zeigen konnten, wird erst durch einen relativ geringen Schwefelanteil in der Pufferschicht 5 ein höherer Natriumanteil ermöglicht, wobei die für die Bandanpassung in den Solarzellen günstigen Schichteigenschaften erhalten bleiben. Beispielsweise kann mit den in der internationalen Patentanmeldung WO 2011/104235 beschriebenen Möglichkeiten den Schwefelanteil in der Pufferschicht zu reduzieren, die Zusammensetzung gezielt in einen Indium-angereicherten Bereich gesteuert werden. Hierbei gelingt es, die Natriumindiumsulfid-Pufferschicht entweder amorph oder in nanokristalliner Struktur (anstatt kristallin) abzuscheiden, da die in der Pufferschicht vorliegenden Natriumindiumsulfid-Phasen unterschiedliche Kristallstrukturen aufweisen. Auf diese Weise kann eine Eindiffusion von Kupfer aus der Absorberschicht in die Pufferschicht gehemmt werden, was die elektrischen Eigenschaften von Solarzellen, insbesondere Chalkopyrit-Solarzellen, verbessert. Durch die Legierung mit Natrium können die Bandlücke und die Ladungsträgerkonzentration der Pufferschicht 5 eingestellt werden, wodurch sich der elektronische Übergang von der Absorberschicht 4 über die Pufferschicht 5 zur Frontelektrode 7 optimieren lässt. Dies wird im Weiteren näher ausgeführt.

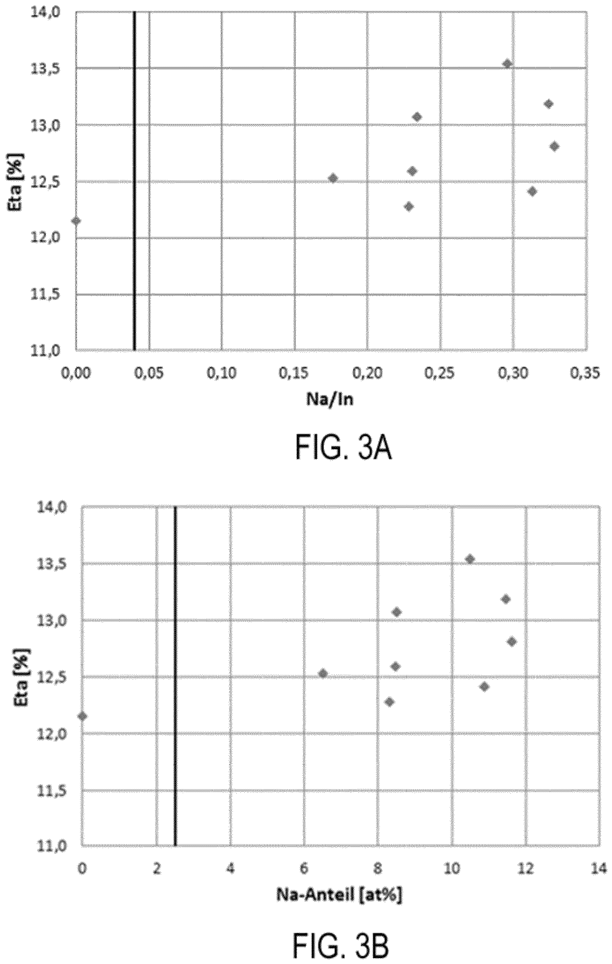

Figur 3A zeigt ein Diagramm, in dem der Wirkungsgrad Eta (Prozent) der Dünnschichtsolarzelle 100 von Figur 1 gegen den Natrium-Indium-Anteil in der Pufferschicht 5 aufgetragen ist. Hierbei handelt es sich um eine entsprechende Projektion aus Fig. 2A. Figur 3B zeigt ein Diagramm, in dem der Wirkungsgrad Eta (Prozent) der Dünnschichtsolarzelle 100 von Figur 1 gegen den absoluten Natriumanteil (Atom-%) in der Pufferschicht 5 aufgetragen ist.

Beispielsweise enthält die hierfür verwendete Dünnschichtsolarzelle 100 ein Substrat 2 aus Glas sowie eine Rückelektrode 3 aus einer Si₃N₄-Barriere-Schicht und einer Molybän-Schicht. Auf der Rückelektrode 3 ist eine Absorberschicht 4 aus Cu(In,Ga)(S,Se)₂ angeordnet, die nach dem oben beschriebenen RTP-Prozess abgeschieden wurde. Auf der Absorberschicht 4 ist eine NaₓIn_{y-x/3}S-Pufferschicht 5 mit 0,063 ≤ x ≤ 0,625 und 0,681 ≤ y ≤ 1,50 angeordnet. Die Schichtdicke der Pufferschicht 5 beträgt 50 nm. Auf der Pufferschicht 5 ist eine 100 nm dicke zweite Pufferschicht 6 angeordnet, die undotiertes Zinkoxid enthält. Auf der zweiten Pufferschicht 6 ist eine 1200 nm dicke Frontelektrode 7 angeordnet, die n-leitendes Zinkoxid enthält. Die Fläche der Dünnschichtsolarzelle 100 beträgt beispielsweise 1,4 cm².

In Figur 3A und 3B ist erkennbar, dass durch eine Erhöhung des Natrium-Indium-Anteils (Na/In > 0,2) bzw. durch eine Erhöhung des absoluten Natriumgehalts (Na > 7 Atom-%) der Pufferschicht 5 der Wirkungsgrad der Dünnschichtsolarzelle 100 gegenüber herkömmlichen Dünnschichtsolarzellen erheblich gesteigert werden kann. Wie bereits ausgeführt, kann ein derart hoher Natriumanteil in der Pufferschicht 5 nur durch einen relativ niedrigen Schwefelanteil erreicht werden. Mit dem erfindungsgemäßen Aufbau konnten hohe Wirkungsgrade von bis zu 13,5 % erreicht werden.

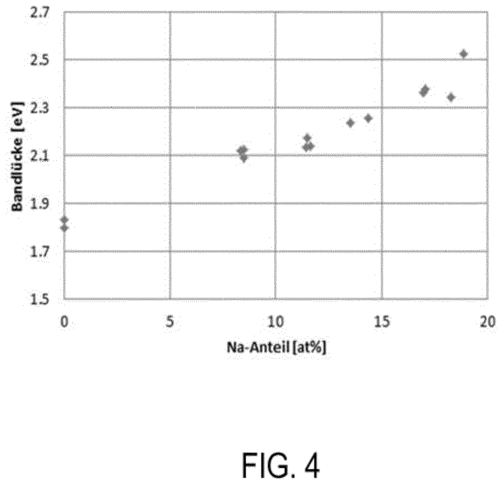

Fig. 4 zeigt für das vorstehend beschriebene Schichtsystem 1 eine Messung der Bandlücke der Pufferschicht 5 in Abhängigkeit des Natriumanteils der Pufferschicht 5. Demnach kann bei einem Natriumanteil von mehr als 7 Atom-% eine Vergrößerung der Bandlücke von 1,8 eV auf 2,5 eV beobachtet werden. Durch die erfindungsgemäße Pufferschicht 5 kann somit eine deutliche Verbesserung des Wirkungsgrads der Dünnschichtsolarzelle 100, ohne eine Verschlechterung der elektrischen Schichteigenschaften (gute Bandanpassung zu Absorber bzw. Frontelektrode durch nicht zu große Bandlücke) erreicht werden.

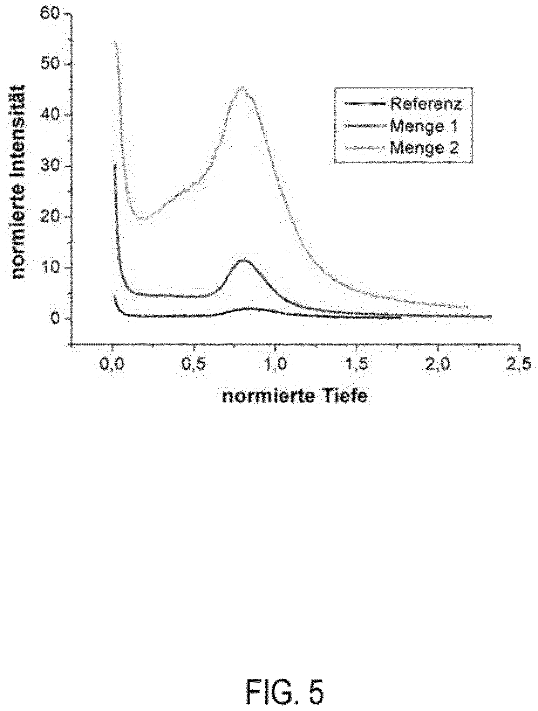

Figur 5 zeigt ein durch eine ToF-SIMS-Messung erzeugtes Tiefenprofil der Natriumverteilung in der Pufferschicht 5 des Schichtsystems 1 von Fig. 1. Als Abszisse ist die normierte Tiefe, als Ordinate die normierte Signalintensität aufgetragen. Hierbei markiert der Bereich von 0 bis 1 der Abszisse die Pufferschicht 5 und der Bereich mit Werten größer als 1 die Absorberschicht 4. Als Ausgangsmaterialien für die Natriumlegierung der Indiumsulfidschicht wurden Verbindungen von Natrium mit dem Chalcogen Schwefel (S) eingesetzt, vorzugsweise Na₂S. Gleichermaßen denkbar wäre auch, eine Verbindung von Natrium mit Schwefel und Indium zu verwenden, beispielsweise NaIn₃S₅. In der Pufferschicht 5, die jeweils auf einer CIGSSe-Absorberschicht 4 aufgebracht ist, sind unterschiedlich hohe Natriumanteile enthalten (Menge 1, Menge 2). Als Referenz wurde eine nicht mit Natrium legierte Indiumsulfid-Pufferschicht verwendet.

Erkennbar entsteht im Schichtstapel durch die Natriumlegierung eine Erhöhung des Natriumanteils, wobei trotz gleichförmiger Abscheidung der Legierung an der Absorber-Puffer-Grenzfläche durch Diffusionsmechanismen eine leichte Anreicherung des Natriumanteils in der Pufferschicht 5 ("Dotierpeak") entsteht. Die Pufferschicht 5 kann zumindest gedanklich in zwei Bereiche unterteilt werden, nämlich einen an die Absorberschicht angrenzenden ersten Schichtbereich und einen an den ersten Schichtbereich angrenzenden zweiten Schichtbereich, wobei die Schichtdicke des ersten Schichtbereichs beispielsweise gleich der Schichtdicke des zweiten Schichtbereichs ist. Demnach weist der Stoffmengenanteil von Natrium im ersten Schichtbereich ein Maximum auf und nimmt sowohl zur Absorberschicht 4 als auch zum zweiten Schichtbereich hin ab. In der Pufferschicht 5 bleibt über die gesamte Schichtdicke eine bestimmte Natriumkonzentration erhalten. Die Akkumulation von Natrium an der Absorber-Puffer-Grenzfläche ist vermutlich auf eine hohe Defektdichte an dieser Stelle zurückzuführen.

Neben Natrium kann sich ebenfalls Sauerstoff (O) oder Zink (Zn), beispielsweise durch Diffusion aus dem TCO der Frontelektrode 7, in der Pufferschicht 5 anreichern. Aufgrund der hygroskopischen Eigenschaften der Ausgangsmaterialien ist eine Anreicherung von Wasser aus der Umgebungsluft ebenfalls denkbar. Besonders vorteilhaft ist der Halogenanteil in der erfindungsgemäßen Pufferschicht gering, wobei der Stoffmengenanteil an einem Halogen, beispielsweise Chlor, weniger als 5 Atom-%, insbesondere weniger als 1 Atom-%, beträgt. Besonders vorteilhaft ist die Pufferschicht 5 halogenfrei.

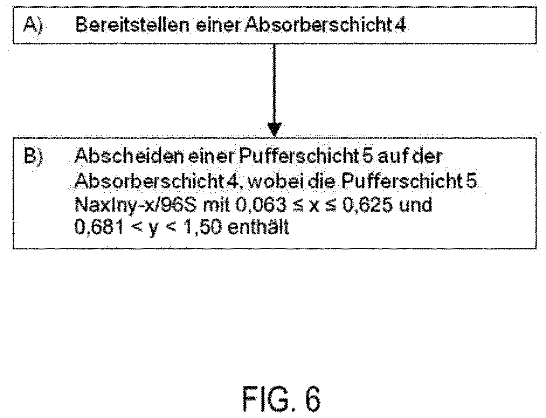

Figur 6 zeigt ein Flussdiagramm eines erfindungsgemäßen Verfahrens. In einem ersten Schritt wird eine Absorberschicht 4 beispielsweise aus einem Cu(In,Ga)(S,Se)₂-Halbleitermaterial bereitgestellt. In einem zweiten Schritt wird die Pufferschicht 5 aus Natriumindiumsulfid abgeschieden. Das Verhältnis der einzelnen Komponenten in der Pufferschicht 5 wird beispielsweise durch eine Steuerung der Aufdampfrate geregelt, beispielsweise durch eine Blende oder eine Temperatursteuerung. In weiteren Prozessschritten kann eine zweite Pufferschicht 6 und eine Frontelektrode 7 auf der Pufferschicht 5 abgeschieden werden. Des Weiteren kann eine Verschaltung und Kontaktierung der Schichtstruktur 1 zu einer Dünnschichtsolarzelle 100 oder einem Solarmodul erfolgen.

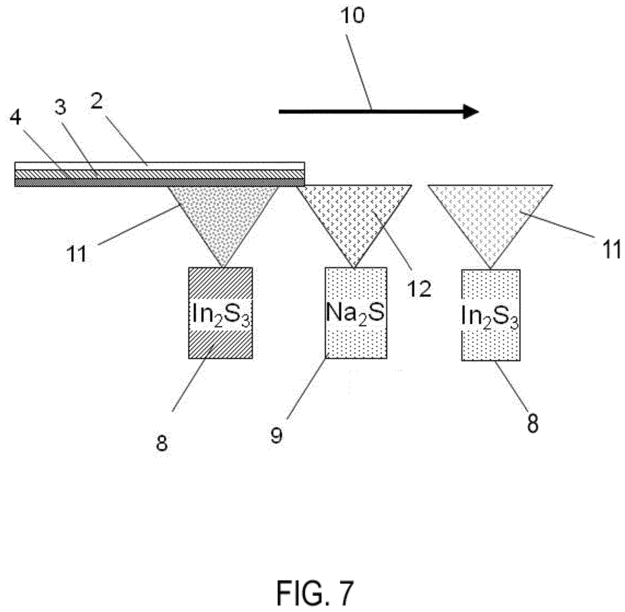

Figur 7 zeigt eine schematische Darstellung eines In-Line-Verfahrens zur Herstellung einer erfindungsgemäßen Pufferschicht 5 aus Natriumindiumsulfid. Das Substrat 2 mit Rückelektrode 3 und Absorberschicht 4 wird in einem In-Line-Verfahren an den Dampfkeulen 11,12 von beispielsweise einer Indiumsulfid-Quelle 8, vorzugsweise In₂S₃, einer Natriumsulfid-Quelle 9, vorzugsweise Na₂S, sowie einer zweiten Indiumsulfid-Quelle 8, vorzugsweise In₂S₃, vorbeigeführt. Die Transportrichtung ist durch einen Pfeil mit dem Bezugszeichen 10 angegeben. Die Natriumsulfid-Quelle 9 ist in Transportrichtung 10 zwischen den beiden Indiumsulfid-Quellen 8 angeordnet, wobei sich die Dampfkeulen 11, 12 nicht überlappen. Auf diese Weise wird die Absorberschicht 4 zunächst mit einer dünnen Schicht aus Indiumsulfid, anschließend mit einer dünnen Schicht aus Natriumsulfid, sowie anschließend erneut mit einer dünnen Schicht aus Indiumsulfid beschichtet, die sich vermischen. Die Natriumsulfid-Quelle 9 und die Indiumsulfid-Quellen 8 sind beispielsweise Effusionszellen, aus denen Natriumsulfid beziehungsweise Indiumsulfid thermisch verdampft wird. Durch die nicht überlappenden Quellen ist eine besonders einfache Prozesskontrolle ermöglicht. Denkbar wäre, eine beliebige Anzahl von Natriumsulfid-Quellen 9 und eine beliebige Anzahl von Indiumsulfid-Quellen 8 mit nicht überlappenden Quellen in Transportrichtung 10 vorzugweise alternierend anzuordnen, vorzugsweise beginnend mit einer Natriumsulfid-Quelle 9.

Alternativ ist jede andere Form der Erzeugung von Dampfkeulen 11,12 zur Abscheidung der Pufferschicht 5 geeignet, sofern sich das Verhältnis der Stoffmengenanteile von Natrium, Indium und Schwefel steuern lässt. Alternative Quellen sind beispielsweise Schiffchen von Linearverdampfern oder Tiegel von Elektronenstrahlverdampfern.

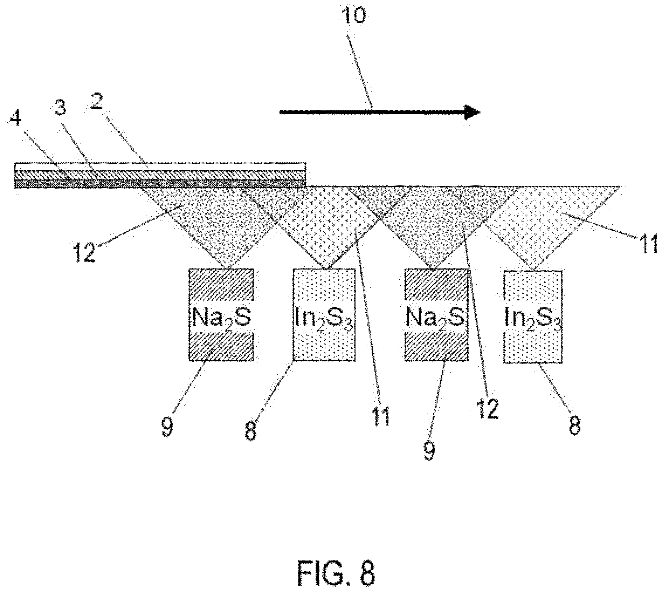

In Figur 8 ist eine alternative Vorrichtung zur Durchführung des erfindungsgemäßen Verfahrens gezeigt, wobei lediglich die Unterschiede zur Vorrichtung von Figur 7 erläutert werden und ansonsten auf obige Ausführungen Bezug genommen wird. Demnach wird das Substrat 2 in einem In-Line-Verfahren an den Dampfkeulen 11,12 von zwei Natriumsulfid (Na₂S)-Quellen 9 und zwei Indiumsulfid (In₂S₃)-Quellen 8 vorbeigeführt, die in Transportrichtung 10 alternierend (Na₂S - In₂S₃ - Na₂S - In₂S₃) angeordnet sind (beginnend mit einer Natriumsulfid-Quelle), wobei sich die Dampfkeulen 11, 12 hier beispielsweise teilweise überlappen. Denkbar wäre auch, dass sich die Dampfkeulen vollständig überlappen. Somit wird Natriumsulfid vor und auch während des Aufbringens von Indiumsulfid aufgebracht, wodurch eine besonders gute Vermischung von Natriumsulfid und Indiumsulfid erreicht werden kann. Denkbar wäre, eine beliebige Anzahl von Natriumsulfid-Quellen 9 und eine beliebige Anzahl von Indiumsulfid-Quellen 8 mit teilweise oder vollständig überlappenden Quellen in Transportrichtung 10 vorzugsweise alternierend anzuordnen, vorzugsweise beginnend mit einer Natriumsulfid-Quelle 9.

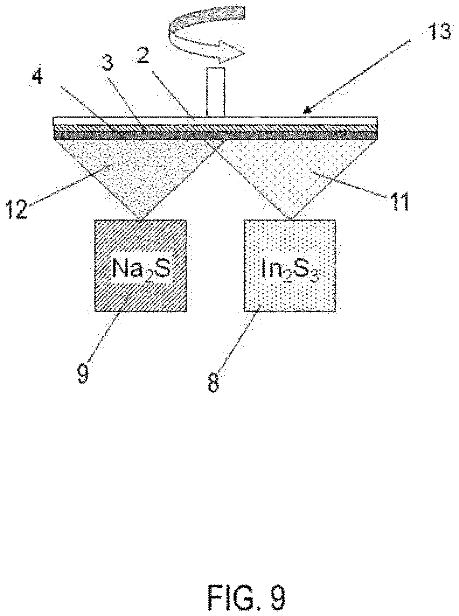

Figur 9 zeigt eine weitere alternative Ausführungsform des erfindungsgemäßen Verfahrens am Beispiel eines Rotations-Verfahrens. Das Substrat 2 mit Rückelektrode 3 und Absorberschicht 4 ist auf einem drehbaren Probenträger 13 angeordnet, beispielsweise auf einem Probenkarussell. Unterhalb des Probenträgers 13 befinden sich alternierend angeordnete Quellen von Natriumsulfid 9 und Indiumsulfid 8. Während der Abscheidung der erfindungsgemäßen Pufferschicht 5 wird der Probenträger 13 gedreht. Dadurch wird das Substrat 2 in den Dampfkeulen 11,12 bewegt und beschichtet.

Die gezeigten Anordnungen zur Verdampfung von Natriumsulfid lassen sich leicht in bestehende thermische Indiumsulfid-Beschichtungsanlagen integrieren.

Aus den vorstehenden Ausführungen ist klar geworden, dass durch die vorliegende Erfindung die Nachteile von bisher verwendeten CdS-Pufferschichten bei Dünnschichtsolarzellen überwunden werden konnten, wobei der Wirkungsgrad und die Stabilität der damit erzeugten Dünnschichtsolarzellen ebenfalls sehr gut oder besser ist. Gleichzeitig ist das Herstellungsverfahren kostengünstig, effektiv und umweltschonend. Es hat sich gezeigt, dass mit dem erfindungsgemäßen Schichtsystem vergleichbar gute Solarzellencharakteristika erreicht werden können, wie sie bei herkömmlichen CdS-Pufferschichten vorliegen.

### Bezugszeichenliste

- 1: Schichtsystem
- 2: Substrat
- 3: Rückelektrode
- 4: Absorberschicht
- 5: Pufferschicht
- 6: zweite Pufferschicht
- 7: Frontelektrode
- 8: Indiumsulfid-Quelle
- 9: Natriumsulfid-Quelle
- 10: Transportrichtung
- 11: Indiumsulfid-Dampfkeule
- 12: Natriumulfid-Dampfkeule
- 13: Probenträger
- 100: Dünnschichtsolarzelle

## Patentansprüche

1. Schichtsystem (1) für Dünnschichtsolarzellen (100), welches umfasst:
- eine Absorberschicht (4) zur Absorption von Licht,
- eine auf der Absorberschicht (4) angeordnete Pufferschicht (5), welche NaₓIn_{y-x/3}S mit
0,063 ≤ x ≤ 0,625,
0,681 ≤ y ≤ 1,50
enthält, wobei der prozentuale Anteil aller Elemente von NaₓIn_{y-x/3}S in der Pufferschicht (5) mindestens 75 Atom-% beträgt,
bei welchem in der Pufferschicht (5) das Verhältnis der Stoffmengenanteile von Natrium und Indium größer als 0,2 ist.

2. Schichtsystem (1) nach Anspruch 1, bei welchem die Pufferschicht (5) NaₓIn_{y-x/3}S mit
0,063 ≤ x ≤ 0,469,
0,681 ≤ y ≤ 1,01
enthält.

3. Schichtsystem (1) nach Anspruch 1, bei welchem die Pufferschicht (5) NaₓIn_{y-x/3}S mit
0,13 ≤ x ≤ 0,32,
0,681 ≤ y ≤ 0,78
enthält.

4. Schichtsystem (1) nach einem der Ansprüche 1 bis 3, bei welchem die Pufferschicht (5) einen Stoffmengenanteil an Natrium von mehr als 5 Atom-% aufweist.

5. Schichtsystem (1) nach einem der Ansprüche 1 bis 4, bei welchem die Pufferschicht (5) einen Stoffmengenanteil an einem Halogen oder an Kupfer von weniger als 7 Atom-% enthält.

6. Schichtsystem (1) nach einem der Ansprüche 1 bis 5, bei welchem die Pufferschicht (5) einen Stoffmengenanteil an Sauerstoff von weniger als 10 Atom-% enthält.

7. Schichtsystem (1) nach einem der Ansprüche 1 bis 6, bei welchem die Pufferschicht (5) eine Schichtdicke von 10 nm bis 100 nm aufweist, wobei die Pufferschicht (5) amorph oder feinkristallin ist.

8. Schichtsystem (1) nach einem der Ansprüche 1 bis 7, bei welchem die Absorberschicht (4) einen Chalkopyritverbindungshalbleiter enthält.

9. Dünnschichtsolarzelle (100), welche umfasst:
- ein Substrat (2),
- eine Rückelektrode (3), die auf dem Substrat (2) angeordnet ist,
- ein Schichtsystem (1) nach einem der Ansprüche 1 bis 8, das auf der Rückelektrode (3) angeordnet ist, und
- eine Frontelektrode (7), die auf dem Schichtsystem (1) angeordnet ist.

10. Verfahren zur Herstellung eines Schichtsystems (1) für Dünnschichtsolarzellen (100) nach einem der Ansprüche 1 bis 8, wobei
a) eine Absorberschicht (4) hergestellt wird, und
b) eine Pufferschicht (5) auf der Absorberschicht (4) hergestellt wird, wobei die Pufferschicht (5) NaₓIn_{y-x/3}S mit
0,063 ≤ x ≤ 0,625,
0,681 ≤ y ≤ 1,50
enthält, wobei der prozentuale Anteil aller Elemente von NaₓIn_{y-x/3}S in der Pufferschicht (5) mindestens 75 Atom-% beträgt.

11. Verfahren nach Anspruch 10, bei welchem zur Herstellung der Pufferschicht (5) in Schritt b)
- Indiumsulfid auf die Absorberschicht (4) abgeschieden wird, und
- vor und/oder während und/oder nach der Abscheidung von Indiumsulfid ein Natriumsulfid oder ein Natriumindat auf die Absorberschicht (4) abgeschieden wird.

12. Verfahren nach Anspruch 10 oder 11, bei welchem Natriumsulfid oder Natriumindat durch nasschemische Badabscheidung, Atomic Layer Deposition (ALD), Ion Layer Gas Deposition (ILGAR), Sprühpyrolyse, Chemical Vapour Deposition (CVD) oder Physical Vapor Deposition (PVD), Sputtern, thermisches Verdampfen oder Elektronenstrahlverdampfen abgeschieden wird.

13. Verfahren nach einem der Ansprüche 10 bis 12, bei welchem die Absorberschicht (4) in einem In-Line-Verfahren oder in einem Rotations-Verfahren an mindestens einer Dampfkeule (12) von Natriumsulfid oder Natriumindat und mindestens einer Dampfkeule (11) von Indiumsulfid vorbeigeführt wird.

## Claims

1. A layer system (1) for thin-film solar cells (100), comprising:
- an absorber layer (4) for absorbing light,
- a buffer layer (5) arranged on the absorber layer (4), containing NaₓIn_{y-x/3}S with
0.063 ≤ x ≤ 0.625,
0.681 ≤ y ≤ 1.50
wherein the percentage of all elements of NaₓIn_{y-x/3}S in the buffer layer (5) is at least 75 atom-%,
wherein in the buffer layer (5) the ratio of the mole fractions of sodium and indium is greater than 0.2.

2. The layer system (1) of claim 1, wherein the buffer layer (5) contains NaₓIn_{y-x/3}S with
0.063 ≤ x ≤ 0.469,
0.681 ≤ y ≤ 1.01.

3. The layer system (1) of claim 1, wherein the buffer layer (5) contains NaₓIn_{y-x/3}S with
0.13 ≤ x ≤ 0.32,
0.681 ≤ y ≤ 0.78.

4. The layer system (1) of any of claims 1-3, wherein the buffer layer (5) has a mole fraction of sodium of more than 5 atom-%.

5. The layer system (1) of any of claims 1-4, wherein the buffer layer (5) contains a mole fraction of a halogen or copper of less than 7 atom-%.

6. The layer system (1) of any of claims 1-5, wherein the buffer layer (5) contains a mole fraction of oxygen of less than 10 atom-%.

7. The layer system (1) of any of claims 1-6, wherein the buffer layer (5) has a layer thickness of 10 nm to 100 nm, wherein the buffer layer (5) is amorphous or finely crystalline.

8. The layer system (1) of any of claims 1-7, wherein the absorber layer (4) contains a chalcopyrite compound semiconductor.

9. The thin-film solar cell (100), comprising:
- a substrate (2),
- a back electrode (3) which is arranged on the substrate (2),
- a layer system (1) of any of claims 1-8, which is arranged on the back electrode (3), and
- a front electrode (7) which is arranged on the layer system (1).

10. A method for producing a layer system (1) for thin-film solar cells (100) of any of claims 1-8, wherein
a) an absorber layer (4) is produced, and
b) a buffer layer (5) is produced on the absorber layer (4), wherein the buffer layer (5) contains NaₓIn_{y-x/3}S with
0.063 ≤ x ≤ 0.625,
0.681 ≤ y ≤ 1.50
wherein the percentage of all elements of NaₓIn_{y-x/3}S in the buffer layer (5) is at least 75 atom-%.

11. The method of claim 10, wherein for producing the buffer layer (5) in step b)
- indium sulfide is deposited on the absorber layer (4), and
- prior to and/or during and/or after the deposition of indium sulfide, a sodium sulfide or a sodium indate is deposited on the absorber layer (4).

12. The method of claim 10 or 11, wherein sodium sulfide or sodium indate is deposited by wet-chemical bath deposition, atomic layer deposition (ALD), ion layer gas deposition (ILGAR), spray pyrolysis, chemical vapor deposition (CVD) or physical vapor deposition (PVD), sputtering, thermal evaporation or electron beam evaporation.

13. The method of any of claims 10-12, wherein the absorber layer (4) is conveyed past at least one vapor beam (12) of sodium sulfide or sodium indate and at least one vapor beam (11) of indium sulfide in an in-line method or in a rotation method.

## Revendications

1. Système de couches (1) pour les cellules solaires à couche mince (100), comprenant :
- une couche absorbante (4) pour l'absorption de la lumière,
- une couche tampon (5) disposée sur ladite couche absorbante (4), contenant NaₓIn_{y-x/3}S, dans laquelle :
0,063 ≤ x ≤ 0,625,
0,681 ≤ y ≤ 1,50
**caractérisé en ce que**, le pourcentage de tous les éléments de NaₓIn_{y-x/3}S dans ladite couche tampon (5) est d'au moins 75 Atome-%;
dans ladite couche tampon (5), le rapport des fractions molaires de sodium et d'indium est supérieur à 0,2.

2. Système de couches (1) selon la revendication 1, **caractérisé en ce que** ladite couche tampon (5) contient NaₓIn_{y-x/3}S, dans laquelle :
0,063 ≤ x ≤ 0,469,
0,681 ≤ y ≤ 1,01.

3. Système de couches (1) selon la revendication 1, **caractérisé en ce que** ladite couche tampon (5) contient NaₓIn_{y-x/3}S, dans laquelle :
0,13 ≤ x ≤ 0,32,
0,681 ≤ y ≤ 0,78.

4. Système de couches (1) selon l'une quelconque des revendications 1 à 3, **caractérisé en ce que** ladite couche tampon (5) présente une fraction molaire de sodium supérieure à 5 Atome-%.

5. Système de couches (1) selon l'une quelconque des revendications 1 à 4, **caractérisé en ce que** ladite couche tampon (5) contient une fraction molaire d'halogène ou de cuivre inférieure à 7 Atome-%.

6. Système de couches (1) selon l'une quelconque des revendications 1 à 5, **caractérisé en ce que** ladite couche tampon (5) contient une fraction molaire d'oxygène inférieure à 10 Atome-%.

7. Système de couches (1) selon l'une quelconque des revendications 1 à 6, **caractérisé en ce que** ladite couche tampon (5) présente une épaisseur de couche de 10 nm à 100 nm, ladite couche tampon (5) étant amorphe ou finement cristalline.

8. Système de couches (1) selon l'une quelconque des revendications 1 à 7, **caractérisé en ce que** ladite couche absorbante (4) contient un semi-conducteur composé de chalcopyrite.

9. Cellule solaire à couche mince (100), comprenant :
- un substrat (2),
- une électrode arrière (3) disposée sur ledit substrat (2),
- un système de couches (1) selon l'une quelconque des revendications 1 à 8, qui est disposé sur ledit électrode arrière (3), et
- une électrode avant (7) disposée sur ledit système de couches (1).

10. Procédé de fabrication d'un système de couches (1) pour les cellules solaires à couche mince (100) selon l'une quelconque des revendications 1 à 8, **caractérisé en ce que**,
a) une couche absorbante (4) est fabriquée,
b) une couche tampon (5) est fabriquée sur ladite couche absorbante (4), la couche tampon (5) contenant NaₓIn_{y-x/3}S, dans laquelle :
0,063 ≤ x ≤ 0,625,
0,681 ≤ y ≤ 1,50
**caractérisé en ce que** le pourcentage de tous les éléments de NaₓIn_{y-x/3}S dans ladite couche tampon (5) est d'au moins 75 Atome-%.

11. Procédé selon la revendication 10, **caractérisé en ce que**, pour la fabrication de ladite couche tampon (5) à l'étape b) :
- du sulfure d'indium est déposé sur ladite couche absorbante (4), et
- avant et/ou pendant et/ou après le dépôt du sulfure d'indium, du sulfure de sodium ou de l'indate de sodium est déposé sur ladite couche absorbante (4).

12. Procédé selon la revendication 10 ou 11, **caractérisé en ce que**, ledit sulfure de sodium ou ledit indate de sodium est déposé par dépôt en bain chimique par voie humide, dépôt par couche atomique (ALD), dépôt par couche ionique en phase gazeuse (ILGAR), pyrolyse par pulvérisation, dépôt chimique en phase vapeur (CVD) ou dépôt physique en phase vapeur (PVD), pulvérisation, évaporation thermique ou évaporation par faisceau d'électrons.

13. Procédé selon l'une quelconque des revendications 10 à 12, **caractérisé en ce que**, ladite couche absorbante (4) passe devant au moins un faisceau de vapeur (12) de sulfure de sodium ou d'indate de sodium, et au moins un faisceau de vapeur (11) de sulfure d'indium dans un procédé en ligne ou dans un procédé de rotation.
